# EUROPÄISCHE PATENTSCHRIFT

(11) **EP 3 365 928 B1**
(45) Veröffentlichungstag und Bekanntmachung des Hinweises auf die Patenterteilung: **05.05.2021**
(21) Anmeldenummer: 17787399.9
(22) Anmeldetag: 20.10.2017
(51) Int. Cl.: H01L 41/107, H01L 41/053

(54) **VORRICHTUNG ZUR ERZEUGUNG EINES ATMOSPHÄRENDRUCK-PLASMAS**
DEVICE FOR GENERATING AN ATMOSPHERIC PRESSURE PLASMA
DISPOSITIF DE GÉNÉRATION D'UN PLASMA À PRESSION ATMOSPHÉRIQUE

(30) Priorität: 25.10.2016 DE 102016120324
(43) Veröffentlichungstag der Anmeldung: 29.08.2018
(73) Patentinhaber: TDK Electronics AG, 81671 München (DE)
(72) Erfinder: RINNER, Franz, 8523 Frauental an der Lassnitz (AT); KUDELA, Pavol, 8530 Deutschlandsberg (AT); PUFF, Markus, 8010 Graz (AT)
(74) Vertreter: Epping - Hermann - Fischer
(86) Internationale Anmeldenummer: PCT/EP2017/076891
(87) Internationale Veröffentlichungsnummer: WO 2018/077754

(56) Entgegenhaltungen:
- WO-A1-2017/140531
- DE-A1-102010 055 266
- DE-A1-102013 100 617

## Beschreibung

Vorrichtung zur Erzeugung eines Atmosphärendruck-Plasmas Die vorliegende Erfindung betrifft eine Vorrichtung zur Erzeugung eines Atmosphärendruck-Plasmas. Dabei handelt es sich um ein nicht-thermisches Plasma.

Die Vorrichtung weist insbesondere einen piezoelektrischen Transformator auf, der eine Ausgangsspannung erzeugt, die zur Ionisation eines Prozessgases genutzt werden kann. Die Vorrichtung sollte Bewegungen des piezoelektrischen Transformators, insbesondere in eine longitudinale Richtung, relativ zu einer Halterung der Vorrichtung vermeiden. Gleichzeitig sollte die Halterung jedoch den piezoelektrischen Transformator nicht derart beeinträchtigen, dass Schwingungen des Transformators gedämpft werden, da dadurch die Effizienz der Plasmaerzeugung reduziert würde.

DE 102013100617 A1 zeigt eine Halterung für einen piezoelektrischen Transformator bestehend aus zwei Stiften, die einen Durchlass für eine Durchsteckmontage bilden, in den der piezoelektrische Transformator eingesteckt und gehalten wird. Alternativ kann die Halterung aus flächigen Elementen bestehen.

DE 102010055266 A1 zeigt einen als piezoelektrischen Transformator ausgebildeten Chip, der von einer Haltevorrichtung gehalten wird WO2017140531 offenbart eine Vorrichtung zur Erzeugung eines nicht thermischen Atmosphärendruck Plasmas.

Aufgabe der vorliegenden Erfindung ist es daher, eine Vorrichtung anzugeben, die diese einander zunächst widersprechenden Anforderungen möglichst gut erfüllt.

Die Aufgabe wird durch eine Vorrichtung gemäß dem vorliegenden Anspruch 1 gelöst.

Es wird eine Vorrichtung zur Erzeugung eines Atmosphärendruck-Plasmas vorgeschlagen, die einen piezoelektrischen Transformator und ein erstes Stützelemente aufweist. Der piezoelektrische Transformator liegt auf dem Stützelement auf, wobei der piezoelektrische Transformator auf dem ersten Stützelement an einer Position aufliegt, an der sich ein Schwingungsknoten ausbildet, wenn der piezoelektrische Transformator mit einer Betriebsfrequenz betrieben wird, die kleiner ist als seine Parallelresonanzfrequenz, und wenn der piezoelektrische Transformator zur Erzeugung eines nicht-thermischen Atmosphärendruck-Plasmas verwendet wird.

Durch die Erzeugung des Plasmas wird eine ausgangsseitige Last gebildet. Dadurch kommt es zu einer Verschiebung der Schwingungsknoten. Bei einem homogenen gleichförmigen Stab ohne Piezoeffekt mit einer Länge L, der mit seiner Resonanzfrequenz zu Schwingungen angeregt wird, ist zu erwarten, dass sich Schwingungsknoten in einem Abstand von 1/4 L zu einer eingangsseitigen Stirnseite und in einem Abstand von 3/4 L zu der eingangsseitigen Stirnseite befinden. Es hat sich jedoch gezeigt, dass bei einem piezoelektrischen Transformator, der zur Plasmaerzeugung genutzt wird, die Position der Schwingungsknoten gegenüber den oben genannten Werten 1/4 L und 3/4 L verschoben ist. Dabei spielen verschiedene Effekten eine Rolle, die nachfolgenden erläutert werden. Die vorliegende Erfindung ermöglicht es, die Verschiebung der Position der Schwingungskonten zu berücksichtigen und das erste Stützelement entsprechend zu positionieren. Dadurch kann sichergestellt werden, dass das erste Stützelement den piezoelektrischen Transformator nur minimal dämpft.

Für die Verschiebung der Position der Schwingungsknoten bei einem piezoelektrischen Transformator gegenüber dem homogenen Stab sind insbesondere die folgenden Effekte relevant: Durch die Erzeugung eines Plasmas an der Ausgangsseite des piezoelektrischen Transformators entsteht eine Last, die mit dem piezoelektrischen Transformator wechselwirkt. Durch die Wechselwirkung mit der Last wird die Frequenz, bei der der piezoelektrische Transformator ein Resonanzverhalten zeigt, von seiner Parallelresonanzfrequenz, bei der er ohne Last ein Maximum in seiner Impedanz aufweist und somit ein Resonanzverhalten zeigt, zu einer kleineren Frequenz hin verschoben. Diese kleinere Frequenz kann die Betriebsfrequenz sein, mit der der piezoelektrische Transformator angeregt wird. Dadurch, dass der piezoelektrische Transformator mit einer Betriebsfrequenz angeregt wird, die kleiner ist als die Parallelresonanzfrequenz, kommt es zu einer Änderung der Lage der Schwingungsknoten. Diese werden in Richtung der Ausgangsseite verschoben.

Darüber hinaus weist der piezoelektrische Transformator ein Elastizitätsmodul auf, dessen Verteilung sich von dem Elastizitätsmodul eines homogenen Stabes unterscheidet. Der Elastizitätsmodul im Eingangsbereich ist unterschiedlich von dem Elastizitätsmodul im Ausgangsbereich, da die piezoelektrischen Schichten im Eingangsbereich senkrecht zu dem piezoelektrischen Material im Ausgangsbereich polarisiert sind. Außerdem weist der Eingangsbereich Innenelektroden auf, während der Ausgangsbereich eine monolithische piezoelektrische Schicht aufweist, so dass sich die Dichte des Eingangsbereichs von der Dichte des Ausgangsbereichs unterscheidet. Die unterschiedlichen Elastizitätsmodule von Eingangsbereich und Ausgangsbereich bewirken eine Verschiebung der Schwingungsknoten hin zu der eingangsseitigen Stirnseite.

Der Effekt der Verschiebung der Schwingungsknoten hin zu der eingangsseitigen Stirnseite auf Grund der unterschiedlichen Elastizitätsmodule von Eingangsbereich und Ausgangsbereich kann stärker sein als der Effekt der Verschiebung der Schwingungsknoten hin zu der ausgangsseitigen Stirnseite auf Grund der Anregung mit der Betriebsfrequenz, die kleiner ist als die Parallelresonanzfrequenz.

Die Differenz der Betriebsfrequenz und der Parallelresonanzfrequenz kann zwischen 10 kH und 0,1 kH liegen. Vorzugsweise kann diese Differenz zwischen 8 kH und 0,1 kH, insbesondere zwischen 5 kH und 0,1 kH liegen. Die Betriebsfrequenz wird kleiner gewählt als die Parallelresonanzfrequenz, um zu berücksichtigen, dass das frequenzabhängige Impedanzspektrum sich bei Anliegen einer Last an der Ausgangsseite, welche durch die Plasmaerzeugung entsteht, hin zu kleineren Frequenzen verschiebt. Die Verschiebung der Frequenz, bei der der piezoelektrische Transformator ein Resonanzverhalten zeigt, kann typischer Weise in den hier angegebenen Bereichen liegen.

Die Parallelresonanzfrequenz kann definiert sein als diejenige Frequenz, bei der eine Impedanz des piezoelektrischen Transformators ein Maximum aufweist, wenn an den piezoelektrischen Transformator eine Wechselspannung mit einer Frequenz angelegt wird und der piezoelektrische Transformator kein Plasma erzeugt. Dementsprechend ist die Parallelresonanzfrequenz durch ein Maximum der Impedanz gekennzeichnet, wenn der piezoelektrische Transformator ohne Last betrieben wird.

In einem alternativen Ausführungsbeispiel kann die Betriebsfrequenz, mit der der piezoelektrische Transformator betrieben wird, geringer sein als die Serienresonanzfrequenz. Insbesondere kann die Differenz der Betriebsfrequenz und der Serienresonanzfrequenz dabei zwischen 10 kH und 0,1 kH liegen. Die Serienresonanzfrequenz kann definiert sein als diejenige Frequenz, bei der eine Impedanz des piezoelektrischen Transformators ein Minimum aufweist, wenn an den piezoelektrischen Transformator eine Wechselspannung mit einer Frequenz angelegt wird und der piezoelektrische Transformator kein Plasma erzeugt. Dementsprechend ist die Serienresonanzfrequenz durch ein Minimum der Impedanz gekennzeichnet, wenn der piezoelektrische Transformator ohne Last betrieben wird.

Der piezoelektrische Transformator kann einen Eingangsbereich und einen Ausgangsbereich aufweisen, wobei der Eingangsbereich eine eingangsseitige Stirnseite des piezoelektrischen Transformators aufweist, die vom Ausgangsbereich weg weist, und wobei der Ausgangsbereich eine ausgangsseitige Stirnseite aufweist, die vom Eingangsbereich weg weist. Eine Länge L kann den Abstand von der eingangsseitigen Stirnseite zur ausgangsseitigen Stirnseite angeben. Ein Abstand der Position, auf der der piezoelektrische Transformator auf dem ersten Stützelement aufliegt, zu der eingangsseitigen Stirnseite kann in einem Bereich zwischen 1/4 L - 5 mm und 1/4 L - 0,05 mm liegen. Dabei wird jeweils der Mittelpunkt des Stützelementes in longitudinaler Richtung betrachtet. Als longitudinale Richtung kann dabei die Richtung bezeichnet werden, die senkrecht zu der eingangsseitigen Stirnseite und senkrecht zu der ausgangsseitigen Stirnseite ist. Vorzugsweise kann der Abstand in einem Bereich zwischen 1/4 L - 3 mm und 1/4 L - 0,05 mm, insbesondere zwischen 1/4 L - 1,5 mm und 1/4 L - 0,05 mm, liegen.

Die Länge L kann beispielsweise zwischen 50 mm und 100 mm liegen, vorzugsweise beträgt L 72 mm. Es hat sich gezeigt, dass ein erster Schwingungsknoten um wenige mm hin zu der eingangsseitigen Stirnseite gegenüber der theoretisch für einen homogenen Stab zu erwartenden Position von 1/4 L verschoben werden. Durch eine Wahl der Position des ersten Stützelementes in dem oben angegebenen Bereich kann es ermöglicht werden, das Stützelement an den tatsächlichen Schwingungsknoten, der sich bei Betrieb des piezoelektrischen Transformators ausbildet, anzuordnen. Dadurch kann sichergestellt werden, dass das erste Stützelement den piezoelektrischen Transformator nur minimal dämpft und so die Effizienz bei der Plasmaerzeugung nicht verschlechtert.

Der Eingangsbereich des piezoelektrischen Transformators kann dazu ausgestaltet sein, eine angelegte Wechselspannung in eine mechanische Schwingung zu wandeln, wobei der Ausgangsbereich dazu ausgestaltet ist, eine mechanische Schwingung in eine elektrische Spannung zu wandeln. Der Ausgangsbereich kann sich in der longitudinalen Richtung unmittelbar an den Eingangsbereich anschließen.

Die Vorrichtung kann ferner ein zweites Stützelement aufweisen, auf dem der piezoelektrische Transformator aufliegt, wobei der piezoelektrische Transformator an dem zweiten Stützelement an einer Position aufliegt, an der sich ein Schwingungsknoten ausbildet, wenn der piezoelektrische Transformator mit der Betriebsfrequenz betrieben wird und der piezoelektrische Transformator zur Erzeugung eines nicht-thermischen Atmosphärendruck-Plasmas verwendet wird.

Das erste und das zweite Stützelement können an verschiedenen Positionen des piezoelektrischen Transformators angeordnet sein. Der Ausgangsbereich des piezoelektrischen Transformators kann auf dem zweiten Stützelement aufliegen. Der Eingangsbereich des piezoelektrischen Transformators kann auf dem ersten Stützelement aufliegen.

Insbesondere kann die Vorrichtung mehrere erste Stützelemente, die jeweils im gleichen Abstand zu der eingangsseitigen Stirnseite angeordnet sind, und mehrere zweite Stützelemente, die jeweils im gleichen Abstand zu der eingangsseitigen Stirnseite angeordnet sind, aufweisen.

Ein Abstand der Position, auf der der piezoelektrische Transformator auf dem zweiten Stützelement aufliegt, zu der eingangsseitigen Stirnseite kann in einem Bereich zwischen 3/4 L - 0,5 mm und 3/4 L - 0,05 mm liegen. Vorzugsweise kann der Abstand in einem Bereich zwischen 3/4 L - 3 mm und 3/4 L - 0,05 mm, insbesondere zwischen 3/4 L - 1,5 mm und 3/4 L - 0,05 mm, liegen. Auch die Position des Schwingungsknotens, der im Ausgangsbereich des piezoelektrischen Transformators ausgebildet wird, kann aufgrund der oben diskutierten Effekte hin zu der Eingangsseite des piezoelektrischen Transformators verschoben sein.

Der Abstand der Position, auf der der piezoelektrische Transformator auf dem ersten Stützelement aufliegt, zu der eingangsseitigen Stirnseite kann 1/4 L - A betragen. Der Abstand der Position, auf der der piezoelektrische Transformator auf dem zweiten Stützelement aufliegt, zu der eingangsseitigen Stirnseite kann 3/4 L - B betragen. B kann größer als A sein. Es hat sich gezeigt, dass im Ausgangsbereich des piezoelektrischen Transformators die Verschiebung des Schwingungsknotens hin zu der eingangsseitigen Stirnseite größer ist als in dem Eingangsbereich. Durch die Wahl von B > A kann dieser Effekt bei der Positionierung der Stützelemente berücksichtigt werden.

Das erste Stützelement kann derart ausgestaltet sein, dass es sich bei einer Stauchung und bei einer Dehnung des piezoelektrischen Transformators elastisch verformt. Dieses kann auch auf das zweite Stützelement zutreffen. Durch die elastische Verformung kann das erste Stützelement federnd wirken. Das erste und das zweite Stützelement können insbesondere zusammen mit dem piezoelektrischen Transformator ein schwingendes System bilden. Da das erste Stützelement und gegebenenfalls auch das zweite Stützelement somit mit einem piezoelektrischen Transformator mit schwingt, dämpfen die Stützelemente die Schwingung des Transformators nicht. Dadurch kann sichergestellt werden, dass keine Energie durch die Stützelemente verloren geht.

Das erste Stützelement kann ein Material ausgewählt aus Polybutylenterephthalat, Polyterafluortylen, Polyamid oder Polyamid aufweisend Glasfaseranteile aufweisen. Auch das zweite Stützelement kann eines dieser Materialien aufweisen. Die Materialien zeichnen sich durch eine besonders große Härte und dementsprechend einen hohen Gütefaktor aus. Dementsprechend erfahren diese Materialien kaum eine plastische Verformung. Dadurch kann sichergestellt werden, dass die aus diesen Materialien gefertigten Stützelemente eine Schwingung des piezoelektrischen Transformators nicht dämpfen.

Das erste Stützelement kann in eine Richtung hin zu dem piezoelektrischen Transformator eine keilförmig zugespitzte Form aufweisen und dementsprechend an dem piezoelektrischen Transformator nahezu linienförmig anliegen. Auch das zweite Stützelement kann eine zum piezoelektrischen Transformator hin keilförmig zugespitzte Form aufweisen. Durch die keilförmig zugespitzte Form kann es ermöglicht werden, dass die Fläche, an der der piezoelektrische Transformator an den Stützelementen aufliegt, möglichst gering ausgestaltet wird. Auch dadurch kann sichergestellt werden, dass die Stützelemente nicht zu einer Dämpfung der Schwingung des piezoelektrischen Transformators führen.

Der piezoelektrische Transformator kann dazu ausgestaltet sein, an der ausgangsseitigen Stirnseite ein nicht-thermisches Atmosphärendruck-Plasma zu erzeugen. Der piezoelektrische Transformator kann beispielsweise ein Transformator vom Rosen-Typ sein.

Ein weiterer Aspekt der vorliegenden Erfindung betrifft einen Plasmagenerator, der die oben beschriebene Vorrichtung sowie ein Gehäuse aufweist, in dem die Vorrichtung angeordnet ist.

In dem Gehäuse kann ferner eine Ansteuerschaltung zur Ansteuerung des piezoelektrischen Transformators angeordnet sein. Die Ansteuerschaltung kann es insbesondere ermöglichen, an dem Eingangsbereich des piezoelektrischen Transformators eine Wechselspannung mit der Betriebsfrequenz anzulegen.

Die Ansteuerschaltung kann mit dem piezoelektrischen Transformator über das Kontaktelement elektrisch kontaktiert sein. Der Plasmagenerator kann ferner Mittel aufweisen, um dem piezoelektrischen Transformator ein Prozessgas zuzuführen. Ferner kann das Gehäuse eine Austrittsöffnung aufweisen, aus der das von dem piezoelektrischen Transformator erzeugte Plasma austreten kann. Durch die Gestaltung der Austrittsöffnung kann es möglich sein, einen Plasmastrahl in gewünschter Weise zu formen.

Im Folgenden werden bevorzugte Ausführungsbeispiele der vorliegenden Erfindung anhand der Figuren beschrieben.
Figur 1 zeigt einen piezoelektrischen Transformator in einer perspektivischen Ansicht,
Figur 2 zeigt eine Vorrichtung zur Erzeugung eines Atmosphärendruck-Plasmas,
Figuren 3 bis 14 zeigen Simulationsergebnisse, die eine Verschiebung der Schwingungsknoten bei einem piezoelektrischen Transformator zeigen, und
Figuren 15 bis 17 zeigen Messergebnisse, die die Positionen der Schwingungsknoten bei einem piezoelektrischen Transformator zeigen.

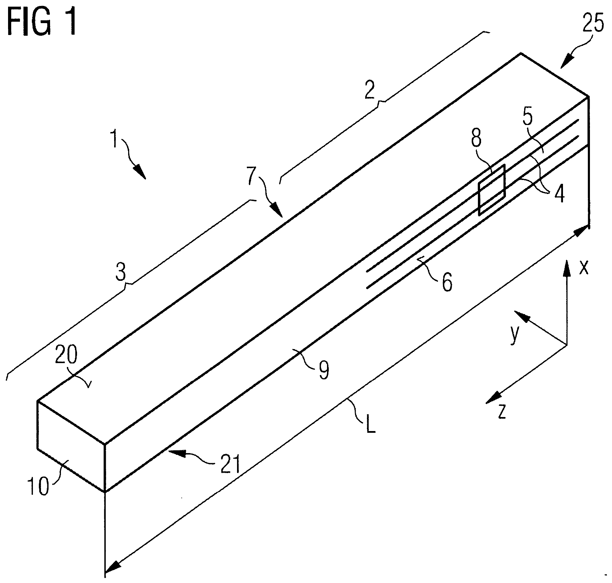

Figur 1 zeigt einen piezoelektrischen Transformator 1 in einer perspektivischen Ansicht. Der piezoelektrische Transformator 1 kann insbesondere in einer Vorrichtung 11 zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer longitudinalen Richtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der longitudinalen Richtung z des piezoelektrischen Transformators 1. Die Elektroden 4 sind in einer Stapelrichtung x, die senkrecht zu der longitudinalen Richtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Ferner weist der piezoelektrische Transformator 1 eine dritte Seitenfläche 20 und eine vierte Seitenfläche 21 auf, die einander gegenüberliegen und die senkrecht zu der ersten Seitenfläche 6 und der zweiten Seitenfläche 7 angeordnet sind. Die Flächennormalen der dritten und der vierten Seitenflächen 20, 21 zeigen jeweils in Stapelrichtung x.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in der longitudinalen Richtung z polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der longitudinalen Richtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite 10 und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Der piezoelektrische Transformator 1 weist ferner eine eingangsseitige Stirnseite 25 auf. Eine Länge L des piezoelektrischen Transformators 1 ist definiert als Abstand von der eingangsseitigen Stirnseite 25 zu der ausgangseitigen Stirnseite 10.

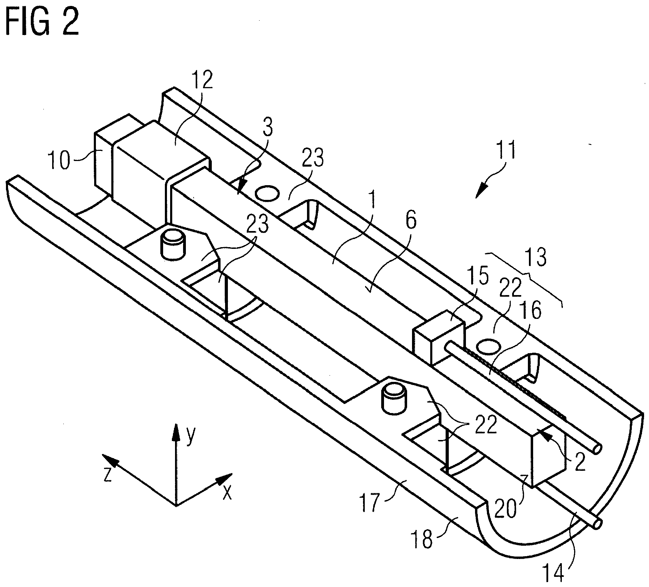

Figur 2 zeigt eine Vorrichtung 11 zur Erzeugung eines Atmosphärendruck-Plasmas. Die Vorrichtung 11 weist den in Figur 1 gezeigten piezoelektrischen Transformator 1 auf. Der piezoelektrische Transformator 1 weist hier zusätzlich eine Isolierung 12 auf, die im Ausgangsbereich 3 des piezoelektrischen Transformators 1 angeordnet ist, wobei die Isolierung 12 die Seitenflächen des Transformators 1 im Ausgangsbereich 3 zumindest teilweise bedeckt und die ausgangsseitige Stirnseite 10 frei von der Isolierung 12 ist. Die Isolierung 12 kann beispielsweise durch einen Schrumpfschlauch gebildet werden. Die Isolierung 12 verhindert, dass entlang der ausgangsseitigen Kanten des piezoelektrischen Transformators 1 unerwünschte Plasmazündungen entstehen. In einem alternativen Ausführungsbeispiel weist der piezoelektrische Transformator 1 keine Isolierung 12 auf.

Ferner weist die Vorrichtung 1 ein erstes Kontaktelement 13 und ein zweites Kontaktelement 14 auf. Das erste Kontaktelement 13 ist mit der ersten Außenelektrode 8 des piezoelektrischen Transformators 1 verbunden. Das zweite Kontaktelement 14 ist mit der zweiten Außenelektrode des piezoelektrischen Transformators 1 verbunden. Über das erste und das zweite Kontaktelement 13, 14 kann an die erste und die zweite Außenelektrode des piezoelektrischen Transformators 1 eine Wechselspannung angelegt werden.

Die Kontaktelemente 13, 14 weisen jeweils einen Draht 15 auf, an dessen einen Ende ein Block 16 angeordnet ist. Der Block 16 der Kontaktelemente 13, 14 ist an der jeweiligen Außenelektrode 8 durch eine nicht-lösbare Befestigung befestigt. Der Block 16 kann beispielsweise durch Löten, Bonden, Kleben oder Mikrosilber-Sintern an der Außenelektrode 8 des piezoelektrischen Transformators 1 befestigt sein. Der Block 16 und der Draht 15 weisen ein leitfähiges Material auf, beispielsweise Kupfer.

Ferner weist die Vorrichtung 11 eine Halterung 17 auf. Die Halterung 17 kann zwei Halbschalen 18, 19 aufweisen. In Figur 2 ist nur eine erste Halbschale 18 der Halterung 17 gezeigt, um eine Darstellung der Verbindung des piezoelektrischen Transformators 1 mit der Halterung 17 zu ermöglichen. Die zweite Halbschale 19 kann identisch zu der in Figur 2 gezeigten Halbschale 18 sein. Bei den Halbschalen 18, 19 handelt es sich um Spritzgusselemente.

Die Halterung 17 weist ein erstes Stützelement 22 und ein zweites Stützelement 23 auf. Insbesondere weist die Halterung 17 mehrere erste Stützelemente 22 auf. Als erstes Stützelement 22 wird jedes Stützelement bezeichnet, an dem der Eingangsbereich 2 des piezoelektrischen Transformators 1 anliegt. Die Halterung 17 weist mehrere zweite Stützelemente 23 auf. Als zweites Stützelement 23 wird jedes Stützelement bezeichnet, an dem der Ausgangsbereich 3 des piezoelektrischen Transformators 1 anliegt.

Die dritte und die vierten Seitenfläche 20, 21 des piezoelektrischen Transformators 1 liegen jeweils an einem der ersten Stützelemente 22 und an einem der zweiten Stützelemente 23 an. In Richtung zu dem piezoelektrischen Transformator 1 hin sind die Stützelemente 22, 23 jeweils keilförmig zugespitzt, sodass sie an dem piezoelektrischen Transformator 1 nahezu linienförmig anliegen. Die Stützelemente 22, 23 sind dabei entlang der longitudinalen Richtung z an den Positionen angeordnet, an denen sich bei Betrieb des Transformators 1 mit seiner Betriebsfrequenz Schwingungsknoten ausbilden.

Durch die Anordnung der Stützelemente 22, 23 an den Schwingungsknoten des piezoelektrischen Transformators 1 sowie durch ihre keilförmige Ausgestaltung wird es ermöglicht, dass die Stützelemente 22, 23 eine Bewegung des piezoelektrischen Transformators 1 in longitudinaler Richtung z nur minimal dämpfen.

Der piezoelektrische Transformator 1 liegt in Stapelrichtung x beidseitig unmittelbar an je einem der ersten Stützelemente 22 und an einem der zweiten Stützelemente 23 an. In Stapelrichtung x liegen jeweils zwei erste Stützelemente 22 und zwei zweite Stützelemente 23 einander gegenüber. Auf diese Weise werden Bewegungen des piezoelektrischen Transformators 1 relativ zu der Halterung 17 in Stapelrichtung x verhindert.

Ferner weist die Halterung 17 erste und zweite Stützelemente 22, 23 auf, zwischen denen der piezoelektrische Transformator 1 in einer y-Richtung eingeschlossen ist, wobei die y-Richtung senkrecht zur Stapelrichtung x und senkrecht zur longitudinalen Richtung z ist. In y-Richtung liegen jeweils zwei erste Stützelemente 22 und zwei zweite Stützelemente 23 einander gegenüber. Auch diese Stützelemente 22, 23 laufen in einer Richtung zu dem piezoelektrischen Transformator 1 hin keilförmig zu und liegen an diesem nahezu linienförmig an. Durch das Anliegen an den Stützelementen 22, 23 wird eine Bewegung des piezoelektrischen Transformators 1 relativ zu der Halterung 17 in y-Richtung verhindert.

Wie oben bereits diskutiert, sind die ersten Stützelemente 22 und die zweiten Stützelemente 23 an Positionen angeordnet, an denen sich bei Betrieb des piezoelektrischen Transformators 1 mit seiner Betriebsfrequenz Schwingungsknoten ausbilden. Bei der Betriebsfrequenz handelt es sich um eine Frequenz, die geringfügig kleiner ist als eine Parallelresonanzfrequenz des piezoelektrischen Transformators.

Wird der piezoelektrische Transformator 1 zur Erzeugung eines nicht-thermischen Atmosphärendruck-Plasmas verwendet, so wirkt dieses als Last. Dadurch verschiebt sich das Frequenzspektrum des piezoelektrischen Transformators 1. Insbesondere liegt nunmehr das Maximum der Impedanz bei einer Frequenz, die kleiner ist als die Parallelresonanzfrequenz, und die als Betriebsfrequenz gewählt werden kann.

Entlang der Länge L des piezoelektrischen Transformators 1 bilden sich bei Betrieb des Transformators 1 mit der Betriebsfrequenz zwei Schwingungsknoten aus. Die ersten Stützelemente 22 sind an der Position angeordnet, an der ein erster Schwingungsknoten ausgebildet wird. Die zweiten Stützelemente 23 sind an der Position angeordnet, an der ein zweiter Schwingungsknoten ausgebildet wird. Der erste Schwingungsknoten liegt im Eingangsbereich 2 des Transformators 1 und der zweite Schwingungsknoten liegt im Ausgangsbereich 3.

Es hat sich gezeigt, dass bei Betrieb des piezoelektrischen Transformators 1 mit der Betriebsfrequenz und bei gleichzeitiger Erzeugung eines Plasmas, das als ausgangsseitige Last wirkt, die Schwingungsknoten in einem Abstand von ¼ L - A und ¾ L - B von der eingangsseitigen Stirnseite 25 erzeugt werden, wobei A > 0 und B > 0. A und B liegen typischerweise in einem Bereich von wenigen Millimetern.

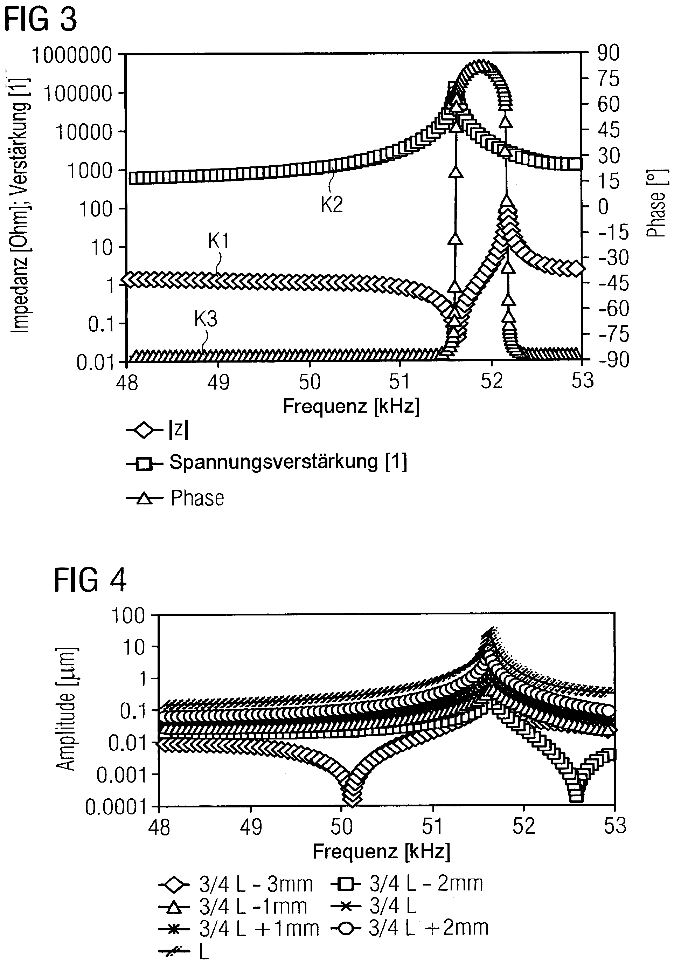

Die Verschiebung der Schwingungsknoten infolge einer anliegenden Last sowie infolge der unterschiedlichen Elastizitätsmodule von Eingangsbereich und Ausgangsbereich wird im Folgenden anhand von Simulationsergebnissen genauer erläutert. In den Figuren 3, 4 und 5 wird jeweils ein piezoelektrischer Transformator 1 mit einer Länge von L = 72 mm betrachtet. Dabei wird ein piezoelektrischer Transformator 1 betrachtet, der kein Plasma erzeugt und an dem keine Last anliegt. In den Figuren 3, 4 und 5 wurde in den Simulationen ein Transformator 1 ohne Innenelektroden 4 betrachtet.

In Figur 3 ist auf der Abszissenachse die Frequenz, die an den Eingangsbereich des piezoelektrischen Transformators angelegt wird, aufgetragen. Die Kurve K1 zeigt den Betrag des Scheinwiderstandes Z des piezoelektrischen Transformators 1 an. Das Maximum der Kurve K1 gibt die Parallelresonanzfrequenz des piezoelektrischen Transformators 1 an. Diese liegt bei ca. 52,3 kHz. Das Minimum der Kurve K1 gibt die Serienresonanzfrequenz des piezoelektrischen Transformators an. Diese liegt bei ca. 51,5 kHz.

Die Kurve K2 zeigt die Spannungsverstärkung in Abhängigkeit von der anliegenden Frequenz. Die Kurve K3 zeigt die Phase.

In Figur 4 wird die Auslenkung betrachtet, die an verschiedenen Positionen des piezoelektrischen Transformators in Abhängigkeit von der anliegenden Frequenz der Wechselspannung auftritt.

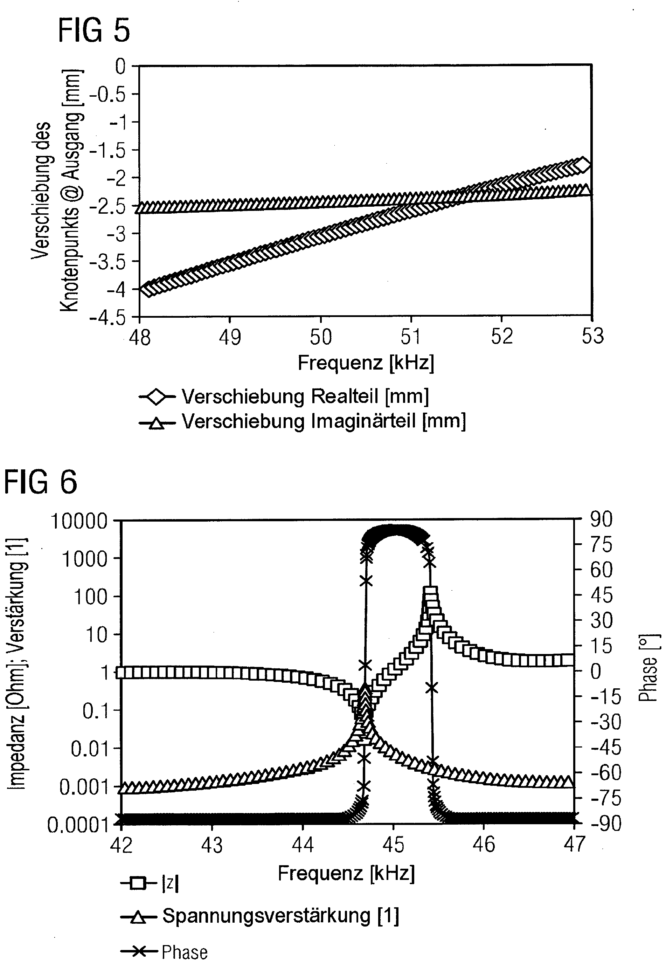

In Figur 5 wird eine Verschiebung des zweiten Schwingungsknotens, der im Ausgangsbereich 3 des piezoelektrischen Transformators 1 ausgebildet wird, in Abhängigkeit von der Frequenz der anliegenden Wechselspannung betrachtet gegenüber der Position 3/4 L betrachtet. Dabei werden Real- und Imaginärteil separat betrachtet. Der Schnittpunkt der beiden in Figur 5 gezeigten Kurven fällt mit der Serienresonanz des piezoelektrischen Transformators zusammen. Hier ist der Schwingungsknoten um 2,4 mm in Richtung der eingangsseitigen Stirnseite 25 verschoben, d.h. der Schwingungsknoten im Ausgangsbereich 3 des piezoelektrischen Transformators 1 befindet sich in einem Abstand von 3/4 L - 2,4 mm von der eingangsseitigen Stirnseite 25.

Wird der Plasmagenerator bei einer Betriebsfrequenz betrieben, die näher an der Parallelresonanz als an der Serienresonanz liegt, so wird der zweite Schwingungsknoten um etwas weniger als 2,4 mm verschoben, wie aus den in Figur 5 gezeigten Kurven ablesbar ist.

In den Figuren 6, 7 und 8 werden die entsprechenden Diagramme dargestellt für einen piezoelektrischen Transformator mit einer Länge von L = 72 mm, bei dem eine ausgangsseitige Last von 1 Ω anliegt. Die Innenelektroden 4 wurden bei den den Figuren zu Grunde liegenden Simulationen mitberücksichtigt.

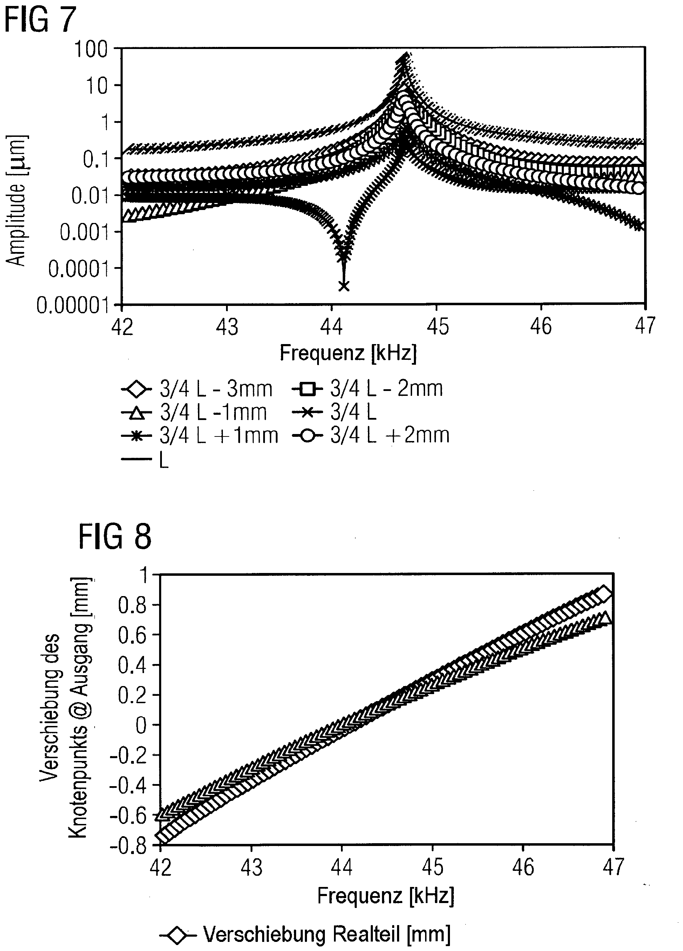

Es ist zu erkennen, dass die Serienresonanzfrequenz und die Parallelresonanzfrequenz sich zu niedrigeren Frequenzen hin verschoben haben. Wie in Figur 8 zu sehen ist, ist der zweite Schwingungsknoten bei der Serienresonanzfrequenz um 0,2 mm in Richtung der ausgangsseitigen Stirnseite 10 verschoben.

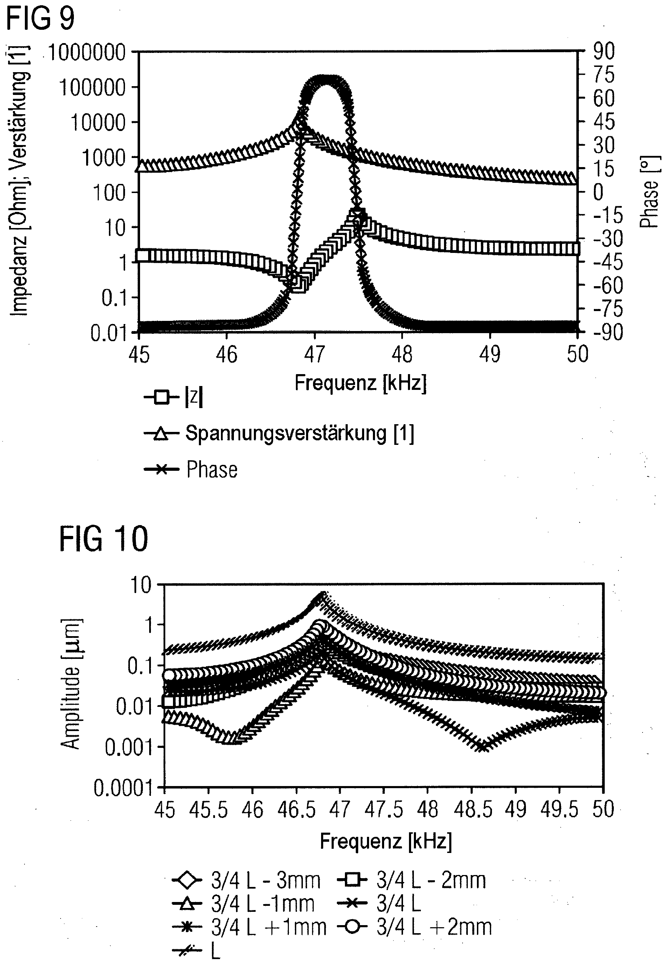

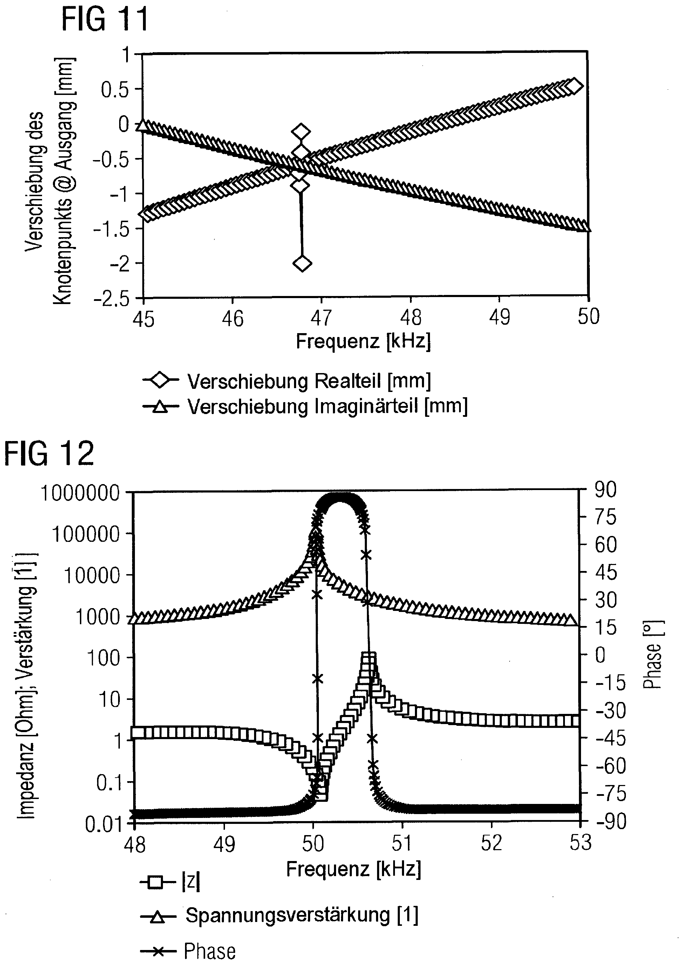

In den Figuren 9, 10 und 11 werden die Diagramme für einen piezoelektrischen Transformator 1 dargestellt, an dem eine Last von 1 Ω seriell zu 10 MΩ und parallel zu 8 pF anliegt. Die Innenelektroden 4 wurden bei den den Figuren zu Grunde liegenden Simulationen mitberücksichtigt. Dieses Szenario entspricht den Bedingungen, die bei einer realen Vorrichtung 11 zur Erzeugung eines Plasmas an dem piezoelektrischen Transformator 1 während der Plasmaerzeugung auftreten. Die Serienresonanzfrequenz liegt nun bei 46,9 kHz. Die Parallelresonanzfrequenz liegt bei 47,5 kHz, wie in Figur 9 gezeigt. Wie in Figur 11 zu sehen ist, ist der zweite Schwingungsknoten bei der Serienresonanzfrequenz um 0,6 mm in Richtung der eingangsseitigen Stirnseite 25 verschoben.

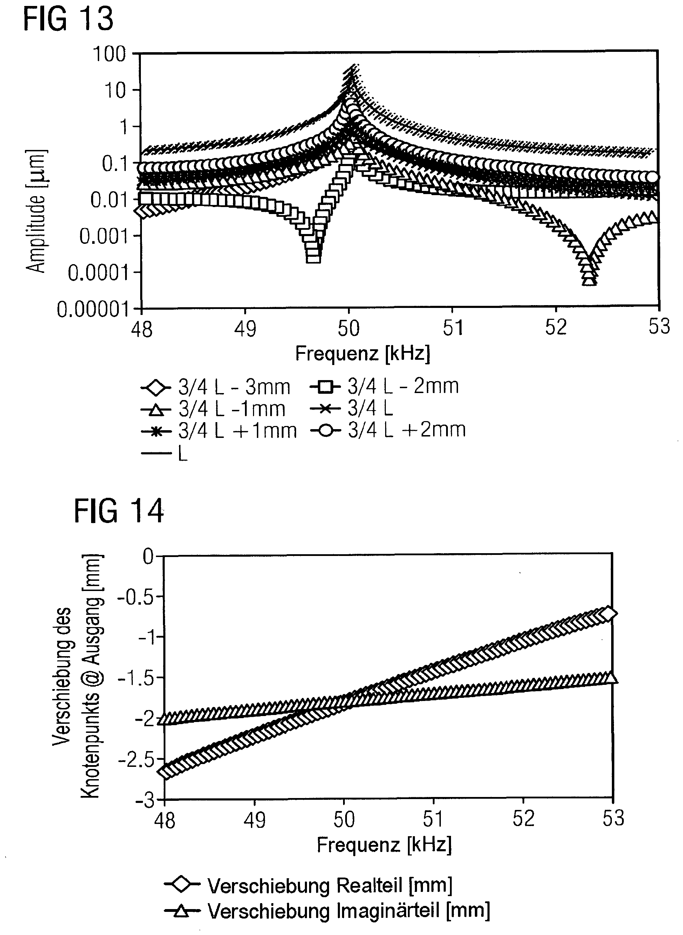

In den Figuren 12 bis 14 sind die Diagramme für einen piezoelektrischen Transformator 1 mit einer Last von 1 Ω seriell zu 10 GΩ parallel zu 1 pF dargestellt. Die Innenelektroden 4 wurden bei den den Figuren zu Grunde liegenden Simulationen mitberücksichtigt. Der zweite Schwingungsknoten ist bei der Serienresonanzfrequenz um 1,9 mm in Richtung der eingangsseitigen Stirnseite 25 verschoben.

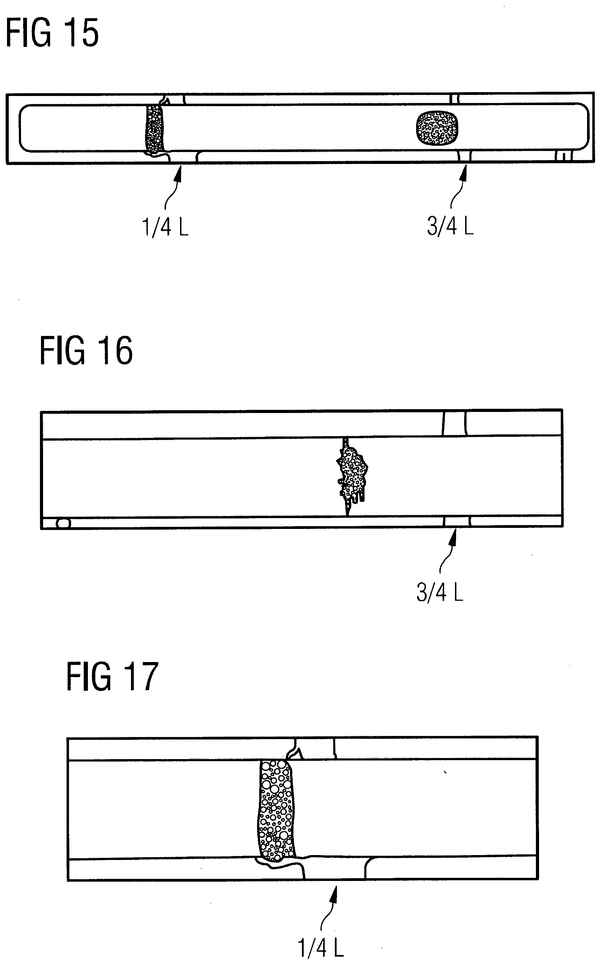

Auch experimentell konnte nachgewiesen werden, dass die Schwingungsknoten sich zu dem Eingangsbereich 2 hin verschieben, wenn der piezoelektrische Transformator 1, dessen Eingangsbereich 2 und Ausgangsbereich 3 unterschiedliche Elastizitätsmodule aufweisen, zur Plasmaerzeugung genutzt wird, wodurch an der ausgangseitigen Stirnseite 10 eine Last entsteht. Die Ergebnisse der experimentellen Untersuchung sind in den Figuren 16 bis 18 dargestellt.

Auf einen piezoelektrischen Transformator 1 wurde ein rieselfähiges Pulver gestreut. Anschließend wurde der piezoelektrische Transformator 1 mit einer Betriebsfrequenz angesteuert. Je weniger sich der Transformator 1 an der jeweiligen Stelle bewegt, umso länger bleibt das Pulver an den entsprechenden Stellen liegen. Dementsprechend zeigen die Stellen, an denen das Pulver liegengeblieben ist, an, wo sich die Schwingungsknoten ausbilden.

Die Abstände von 1/4 L und 3/4 L zu der eingangsseitigen Stirnseite sind in Figur 15 markiert. Es ist zu erkennen, dass der erste Schwingungsknoten einen Abstand zu der eingangsseitigen Stirnseite 25 von weniger als 1/4 L hat und dass der zweite Schwingungsknoten einen Abstand zu der eingangsseitigen Stirnseite 25 von weniger als 3/4 L hat. Der erste und der zweite Schwingungsknoten sind jeweils an dem auf dem Transformator 1 verbliebenen Pulver zu erkennen.

Figur 17 zeigt eine Detailaufnahme des Ausgangsbereichs 3. Es ist zu erkennen, dass im Ausgangsbereich 3 der Schwingungsknoten um zirka 1,5 mm in Richtung der eingangsseitigen Stirnseite von der Position 3/4 L verschoben ist. Figur 18 zeigt eine Detailaufnahme des Eingangsbereichs 2. Im Eingangsbereich ist der Schwingungsknoten um 0,5 mm in Richtung der eingangsseitigen Stirnseite 25 von der Position 1/4 L verschoben. Dementsprechend erfährt der Schwingungsknoten im Ausgangsbereich 3 einen größeren Versatz als der Schwingungsknoten im Eingangsbereich 2.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Vorrichtung zur Erzeugung eines Atmosphärendruck-Plasmas
- 12: Isolierung
- 13: erste Kontaktelement
- 14: zweite Kontaktelement
- 15: Draht
- 16: Block
- 17: Halterung
- 18: erste Halbschale
- 19: zweite Halbschale
- 20: dritte Seitenfläche
- 21: vierte Seitenfläche
- 22: erstes Stützelement
- 23: zweites Stützelement
- 25: eingangsseitige Stirnseite

- x: Stapelrichtung
- y: y-Richtung
- z: longitudinale Richtung
- L: Länge

## Patentansprüche

1. Vorrichtung (11) zur Erzeugung eines nicht-thermischen Atmosphärendruck- Plasmas, aufweisend
- einen piezoelektrischen Transformator (1), und
- ein erstes Stützelement (22),
**dadurch gekennzeichnet, dass**
der piezoelektrische Transformator (1) auf dem ersten Stützelement (22) derart angeordnet ist, dass sich ein Schwingungsknoten an einer Position ausbildet, an der der piezoelektrische Transformator (1) auf dem ersten Stützelement (22) aufliegt, wenn der piezoelektrische Transformator (1) mit einer Betriebsfrequenz betrieben wird, die kleiner ist als seine Parallelresonanzfrequenz, und der piezoelektrische Transformator (1) zur Erzeugung eines nicht-thermischen Atmosphärendruck-Plasmas verwendet wird.

2. Vorrichtung (11) gemäß dem vorherigen Anspruch,
wobei die Differenz der Betriebsfrequenz und der Parallelresonanzfrequenz zwischen um 10kHz und 0.1 kHz liegt.

3. Vorrichtung (11) gemäß einem der vorherigen Ansprüche,
wobei die Parallelresonanzfrequenz definiert ist als diejenige Frequenz, bei der eine Impedanz des piezoelektrischen Transformators (1) ein Maximum aufweist, wenn an den piezoelektrischen Transformator (1) eine Wechselspannung mit der Frequenz angelegt wird und der piezoelektrische Transformator (1) kein Plasma erzeugt.

4. Vorrichtung (11) gemäß einem der vorherigen Ansprüche,
wobei der piezoelektrische Transformator (1) einen Eingangsbereich (2) und einen Ausgangsbereich (3) aufweist, wobei der Eingangsbereich (2) eine eingangsseitige Stirnseite (25) des piezoelektrischen Transformators (1) aufweist, die vom Ausgangsbereich (3) weg weist, wobei der Ausgangsbereich (3) eine ausgangsseitige Stirnseite (10) aufweist, die vom Eingangsbereich (2) weg weist,
wobei eine Länge L den Abstand von der eingangsseitigen Stirnseite (25) zur ausgangsseitigen Stirnseite (10) angibt, und
wobei ein Abstand der Position, auf der piezoelektrische Transformator (1) auf dem ersten Stützelement (22) aufliegt, zu der eingangsseitigen Stirnseite (25) in einem Bereich zwischen ¼ L - 5,0 mm und ¼ L - 0,05 mm liegt.

5. Vorrichtung (11) gemäß dem vorherigen Anspruch,
wobei die Vorrichtung (11) ein Kontaktelement (13, 14) aufweist, das an dem piezoelektrischen Transformator (1) befestigt ist und das dazu ausgelegt ist, an den Eingangsbereich (2) eine Wechselspannung anzulegen, wobei das Kontaktelement (13, 14) an einer Position an dem Eingangsbereich (2) befestigt ist, deren Abstand zur eingangsseitigen Stirnseite (25) mit dem Abstand der Position übereinstimmt, an der das erste Stützelement (22) angeordnet ist.

6. Vorrichtung (11) gemäß einem der Ansprüche 4 oder 5,
wobei der Eingangsbereich (2) dazu ausgestaltet ist, eine angelegte Wechselspannung in eine mechanische Schwingung zu wandeln, wobei der Ausgangsbereich (3) dazu ausgestaltet ist, eine mechanische Schwingung in eine elektrische Spannung zu wandeln.

7. Vorrichtung (11) gemäß einem der vorherigen Ansprüche,
wobei die Vorrichtung (11) ferner ein zweites Stützelement (23) aufweist, auf dem der piezoelektrische Transformator (1) aufliegt, wobei der piezoelektrische Transformator (1) an dem zweiten Stützelement (23) an einer Position aufliegt, an der sich ein Schwingungsknoten ausbildet, wenn der piezoelektrische Transformator (1) mit der Betriebsfrequenz betrieben wird und der piezoelektrische Transformator (1) zur Erzeugung eines nicht-thermischen Atmosphärendruckplasmas verwendet wird.

8. Vorrichtung (11) gemäß dem vorherigen Anspruch,
wobei ein Abstand der Position, auf der der piezoelektrische Transformator (1) auf dem zweiten Stützelement (23) aufliegt, zu der eingangsseitigen Stirnseite (25) in einem Bereich zwischen ¾ L - 5,0 mm und ¾ L - 0,05 mm liegt.

9. Vorrichtung (11) gemäß dem vorherigen Anspruch,
wobei der Abstand der Position, auf der der piezoelektrische Transformator (1) auf dem ersten Stützelement (22) aufliegt, zu der eingangsseitigen Stirnseite (25) ¼ L - A beträgt,
wobei der Abstand der Position, auf der der piezoelektrische Transformator (1) auf dem zweiten Stützelement (23) aufliegt, zu der eingangsseitigen Stirnseite (25) ¾ L - B beträgt, und
wobei B > A ist.

10. Vorrichtung (11) gemäß einem der vorherigen Ansprüche,
wobei das erste Stützelement (22) derart ausgestaltet ist, dass es sich bei einer Stauchung und bei einer Dehnung des piezoelektrischen Transformators (1) elastisch verformt.

11. Vorrichtung (11) gemäß einem der vorherigen Ansprüche,
wobei das erste Stützelement (22) ein Material ausgewählt aus Polybutylenterephthalat, Polytetrafluorethylen, Polyamid oder Polyamid aufweisend Glasfaseranteile aufweist.

12. Vorrichtung (11) gemäß einem der vorherigen Ansprüche,
wobei das erste Stützelement (22) eine in Richtung zu dem piezoelektrischen Transformator (1) hin keilförmig zugespitzte Form aufweist und an dem piezoelektrischen Transformator (1) nahezu linienförmig anliegt.

13. Vorrichtung (11) gemäß einem der vorherigen Ansprüche,
wobei der piezoelektrische Transformator (1) dazu ausgestaltet ist, an der ausgangsseitigen Stirnseite (10) ein nicht-thermisches Atmosphärendruck-Plasma zu erzeugen.

14. Plasmagenerator,
aufweisend eine Vorrichtung (11) gemäß einem der vorherigen Ansprüche und ein Gehäuse, in dem die Vorrichtung (11) angeordnet ist.

15. Plasmagenerator gemäß dem vorherigen Anspruch,
wobei in dem Gehäuse eine Ansteuerschaltung zur Ansteuerung des piezoelektrischen Transformators (1) angeordnet ist.

## Claims

1. A device (11) for generating a non-thermal atmospheric pressure plasma, having
- a piezoelectric transformer (1), and
- a first support element (22),
**characterized in that**
the piezoelectric transformer (1) is arranged on the first support element (22) in such a manner that an oscillation node is realized at a position, at which the piezoelectric transformer (1) rests on the first support element (22), if the piezoelectric transformer (1) is operated at an operational frequency which is less than its parallel resonance frequency, and the piezoelectric transformer (1) is used for generating a non-thermal atmospheric pressure plasma.

2. The device (11) according to the preceding claim,
wherein the difference of the operational frequency and the parallel resonance frequency lies between approximately 10kHz and 0.1 kHz.

3. The device (11) according to any one of the preceding claims,
wherein the parallel resonance frequency is defined as that frequency, at which an impedance of the piezoelectric transformer (1) has a maximum, if an alternating voltage having the frequency is applied to the piezoelectric transformer (1) and the piezoelectric transformer (1) does not generate any plasma.

4. The device (11) according to any one of the preceding claims,
wherein the piezoelectric transformer (1) has an input region (2) and an output region (3), wherein the input region (2) has an input-side end face (25) of the piezoelectric transformer (1) which faces away from the output region (3), wherein the output region (3) has an output-side end face (10) which faces away from the input region (2),
wherein a length L indicates the distance of the input-side end face (25) from the output-side end face (10), and wherein a distance of the position, at which the piezoelectric transformer (1) rests on the first support element (22), from the input-side end face (25) lies in a range between ¼ L - 5.0 mm and ¼ L - 0.05 mm.

5. The device (11) according to the preceding claim,
wherein the device (11) has a contact element (13, 14) which is fastened to the piezoelectric transformer (1) and which is designed to apply an alternating voltage to the input region (2), wherein the contact element (13, 14) is fastened to the input region (2) at a position, the distance of which from the input-side end face (25) corresponds to the distance of the position, at which the first support element (22) is arranged.

6. The device (11) according to any one of Claims 4 or 5,
wherein the input region (2) is configured to convert an applied alternating voltage into a mechanical oscillation, wherein the output region (3) is configured to convert a mechanical oscillation into an electrical voltage.

7. The device (11) according to any one of the preceding claims,
wherein the device (11) further has a second support element (23), on which the piezoelectric transformer (1) rests, wherein the piezoelectric transformer (1) rests against the second support element (23) at a position, at which an oscillation node is realized, if the piezoelectric transformer (1) is operated at the operational frequency and the piezoelectric transformer (1) is used for generating a non-thermal atmospheric pressure plasma.

8. The device (11) according to the preceding claim,
wherein a distance of the position, at which the piezoelectric transformer (1) rests on the second support element (23), from the input-side end face (25) lies in a range between ¾ L - 5.0 mm and ¾ L - 0.05 mm.

9. The device (11) according to the preceding claim,
wherein the distance of the position, at which the piezoelectric transformer (1) rests on the first support element (22), from the input-side end face (25) is ¼ L - A, wherein the distance of the position, at which the piezoelectric transformer (1) rests on the second support element (23), from the input-side end face (25) is ¾ L - B, and wherein B is > A.

10. The device (11) according to any one of the preceding claims,
wherein the first support element (22) is configured in such a manner that it elastically deforms in the event of a buckling and in the event of an elongation of the piezoelectric transformer (1).

11. The device (11) according to any one of the preceding claims,
wherein the first support element (22) has a material selected from polybutylene terephthalate, polytetrafluorethylene, polyamide or polyamide having glass fiber components.

12. The device (11) according to any one of the preceding claims,
wherein the first support element (22) has a shape tapered in the form of a wedge toward the piezoelectric transformer (1) and bears in a virtually linear manner against the piezoelectric transformer (1).

13. The device (11) according to any one of the preceding claims,
wherein the piezoelectric transformer (1) is configured to generate a non-thermal atmospheric pressure plasma on the output-side end face (10).

14. A plasma generator,
having a device (11) according to any one of the preceding claims and a housing, in which the device (11) is arranged.

15. The plasma generator according to the preceding claim,
wherein a trigger circuit for triggering the piezoelectric transformer (1) is arranged in the housing.

## Revendications

1. Dispositif (11) pour générer un plasma non thermique à la pression atmosphérique, présentant
- un transformateur piézoélectrique (1) et
- un premier élément support (22),
**caractérisé en ce que**
le transformateur piézoélectrique (1) est agencé sur le premier élément support (22) de manière telle qu'un nœud d'oscillation se forme en une position dans laquelle le transformateur piézoélectrique (1) est placé sur le premier élément support (22) lorsque le transformateur piézoélectrique (1) est utilisé à une fréquence de fonctionnement inférieure à sa fréquence de résonance parallèle et le transformateur piézoélectrique (1) est utilisé pour générer un plasma non thermique à la pression atmosphérique.

2. Dispositif (11) selon la revendication précédente,
la différence entre la fréquence de fonctionnement et la fréquence de résonance parallèle se situant entre 10 kHz et 0,1 kHz.

3. Dispositif (11) selon l'une quelconque des revendications précédentes,
la fréquence de résonance parallèle étant définie comme la fréquence à laquelle une impédance du transformateur piézoélectrique (1) présente un maximum lorsqu'une tension alternative présentant la fréquence est appliquée au transformateur piézoélectrique (1) et le transformateur piézoélectrique (1) ne génère pas de plasma.

4. Dispositif (11) selon l'une quelconque des revendications précédentes,
le transformateur piézoélectrique (1) présentant une zone d'entrée (2) et une zone de sortie (3), la zone d'entrée (2) présentant une face frontale (25) côté entrée du transformateur piézoélectrique (1) qui s'étend à l'opposé de la zone de sortie (3), la zone de sortie (3) présentant une face frontale (10) côté sortie qui s'étend à l'opposé de la zone d'entrée (2),
une longueur L indiquant la distance depuis la face frontale (25) côté entrée jusqu'à la face frontale (10) côté sortie et une distance depuis la position à laquelle le transformateur piézoélectrique (1) est placé sur le premier élément support (22) jusqu'à la face frontale (25) côté entrée se situant dans une zone entre 1/4 L - 0,5 mm et 1/4 L - 0,05 mm.

5. Dispositif (11) selon la revendication précédente,
le dispositif (11) présentant un élément de contact (13, 14) qui est fixé au transformateur piézoélectrique (1) et conçu pour appliquer une tension alternative à la zone d'entrée (2),
l'élément de contact (13, 14) étant fixé en une position au niveau de la zone d'entrée (2) dont la distance par rapport à la face frontale (25) côté entrée correspond à la distance de la position dans laquelle le premier élément support (22) est agencé.

6. Dispositif (11) selon l'une quelconque des revendications 4 ou 5,
la zone d'entrée (2) étant conçue pour transformer une tension alternative appliquée en une oscillation mécanique, la zone de sortie (3) étant conçue pour transformer une oscillation mécanique en une tension électrique.

7. Dispositif (11) selon l'une quelconque des revendications précédentes,
le dispositif (11) présentant en outre un deuxième élément support (23) sur lequel le transformateur piézoélectrique (1) est placé, le transformateur piézoélectrique (1) se plaçant sur le deuxième élément support (23) en une position dans laquelle un nœud d'oscillation se forme lorsque le transformateur piézoélectrique (1) est utilisé à la fréquence de fonctionnement et le transformateur piézoélectrique (1) étant utilisé pour générer un plasma non thermique à la pression atmosphérique.

8. Dispositif (11) selon la revendication précédente,
une distance entre la position dans laquelle le transformateur piézoélectrique (1) est placé sur le deuxième élément support (23) et la face frontale (25) côté entrée se situant dans une plage entre 3/4 L - 5,0 mm et 3/4 L - 0,05 mm.

9. Dispositif (11) selon la revendication précédente,
la distance entre la position dans laquelle le transformateur piézoélectrique (1) est placé sur le premier élément support (22) et la face frontale (25) côté entrée étant de 1/4 L - A, la distance entre la position dans laquelle le transformateur piézoélectrique (1) est placé sur le deuxième élément support (23) et la face frontale (25) côté entrée étant de 3/4 L - B, et
B étant > A.

10. Dispositif (11) selon l'une quelconque des revendications précédentes,
le premier élément support (22) étant conçu de manière telle qu'il se déforme élastiquement lors d'une compression et lors d'une dilatation du transformateur piézoélectrique (1).

11. Dispositif (11) selon l'une quelconque des revendications précédentes,
le premier élément support (22) présentant un matériau choisi parmi le poly(téréphtalate de butylène), le polytétrafluoroéthylène, le polyamide ou le polyamide présentant des proportions de fibres de verre.

12. Dispositif (11) selon l'une quelconque des revendications précédentes,
le premier élément support (22) présentant une forme cunéiforme effilée vers le transformateur piézoélectrique (1) et s'appliquant de manière quasiment linéaire sur le transformateur piézoélectrique (1).

13. Dispositif (11) selon l'une quelconque des revendications précédentes,
le transformateur piézoélectrique (1) étant conçu pour générer un plasma non thermique à la pression atmosphérique au niveau de la face frontale (10) côté sortie.

14. Générateur de plasma,
présentant un dispositif (11) selon l'une quelconque des revendications précédentes et un boîtier dans lequel est agencé le dispositif (11).

15. Générateur de plasma selon la revendication précédente, un circuit de commande pour commander le transformateur piézoélectrique (1) étant agencé dans le boîtier.
